## Europäisches Patentamt

## European Patent Office

## Office européen des brevets

(19)

(11) Veröffentlichungsnummer: **0 069 901**

**B1**

(12)

# EUROPÄISCHE PATENTSCHRIFT

(45) Veröffentlichungstag der Patentschrift:
**08.04.87**

(21) Anmeldenummer: **82105678.5**

(22) Anmeldetag: **26.06.82**

(51) Int. Cl.⁴: **H 01 L 23/14,** H 01 L 23/48 //
H01L23/04

(54) **Stromrichtermodul.**

(30) Priorität: **11.07.81 DE 3127457**

(43) Veröffentlichungstag der Anmeldung:
**19.01.83 Patentblatt 83/3**

(45) Bekanntmachung des Hinweises auf die Patenterteilung:
**08.04.87 Patentblatt 87/15**

(84) Benannte Vertragsstaaten:
**AT FR GB IT NL SE**

(56) Entgegenhaltungen:
**DE-A-2 819 327**
**DE-A-2 840 514**

ŕ

(73) Patentinhaber: **BROWN, BOVERI & CIE
Aktiengesellschaft, Kallstadter Strasse 1, D-6800
Mannheim 31 (DE)**

(72) Erfinder: **Neidig, Arno, Dr. Dipl.- Phys.,
Brühlerweg 42, D-6831 Plankstadt (DE)**
Erfinder: **Akyürek, Altan, Phys.- Ing. grad.,
Giessener Strasse 4, D-6148 Heppenheim (DE)**
Erfinder: **Hettmann, Hubert, Waldstrasse 16, D-6832
Hockenheim (DE)**

(74) Vertreter: **Kempe, Wolfgang, Dr., c/o BROWN,
BOVERI & CIE AG ZPT Postfach 351, D-6800
Mannheim 31 (DE)**

## Beschreibung

Die Erfindung bezieht sich auf ein Stromrichtermodul mit einem oben und unten offenen Rahmen als Gehäusewandung und einer mit dem Rahmen verklebten Keramikplatte als Gehäuseboden, wobei die Keramikplatte auf ihrer dem Gehäuseinneren zugewandten Seite Metallisierungen aufweist, die als Leiterbahnen zum Verlöten mit Halbleiterbauelementen, internen Verbindungslaschen und externen Anschlußelementen dienen, wobei die Anschlußelemente als auf der Oberseite des Gehäuses frei zugängliche und im Gehäuse mit einer Metallisierung verlötete Flachstecker ausgebildet sind und wobei das Gehäuse mit einer Vergußmasse etwa zur Hälfte ausgegossen ist.

Ein derartiges Stromrichtermodul ist bekannt aus dem Prospekt BBC-Gleichrichter-Brücken hoher Leistung, DHS 104981/29D. Als Halbleiterbauelemente werden dabei insbesondere Thyristoren und Dioden eingesetzt. Mittels derartiger Stromrichtermodule sind vollgesteuerte und halbgesteuerte Einphasenbrücken realisierbar.

Bei normaler Betriebsbelastung des Stromrichtermoduls entsteht im Gehäuseinneren des Moduls Verlustwärme. Dabei dehnt sich die weiche Silikon-Vergußmasse in Gehäuseinneren wegen ihres etwa um eine Größenordnung höheren Ausdehnungskoeffizienten stärker aus als die metallenen, mit der Keramikplatte verbundenen Flachstecker, so daß an diesen starke zyklische Zugspannungen auftreten. Die Flachstecker sind auf dem Substrat mit Weichlot angelötet. Weichlote reagieren jedoch empfindlich auf zyklische Belastungen, es besteht also die Gefahr, daß nach einer Vielzahl von Lastwechselspielen die innere elektrische Verbindung zwischen Anschlußelement und Substrat unterbrochen wird.

Ferner bewirkt die Erwärmung beim Betrieb des Stromrichtermoduls eine lokale thermische Belastung der Keramikplatte über die sich aufheizenden Metallisierungen auf der dem Gehäuseinneren zugewandten Seite der Keramikplatte. Diese Verlustwärme muß über möglichst niedrige Wärmewiderstände zum Kühlkörper hin abgeführt werden. Das Anbringen einer potentialfreien Metallgrundplatte bringt nicht den erhofften Erfolg, da diese Metallgrundplatte durch den "Bimetalleffekt" beim Zusammenlöten des Systems Keramiksubstrat/Metallplatte mit Lotzwischenschicht zur Plattenmitte hin leicht hohl wird. Trotz ausreichenden Auftrags von Wärmeleitpaste besteht die Gefahr des Einschlusses dünner Luftschichten, die den Wärmewiderstand zwischen Metallgrundplatte und Kühlkörper erhöhen.

Um den letzteren Nachteil zu vermeiden, wird bei einer aus der DE-OS 28 40 514 bekannten Lösung die Metallgrundplatte weggelassen, so daß die Keramik direkt mit dem Kühlkörper in Kontakt ist. Diese Ausführung besitzt zwar weniger Wärmeübergänge, sie hat aber den Nachteil, daß die Keramikplatte bei der Handhabung des Moduls leicht beschädigt werden kann. Ein Verlust der Isolationsfähigkeit wäre die Folge. Zum Schutz der Keramikplatte wurde auch vorgeschlagen, eine Folie aus elastomerem Material zwischen das Modul und den Kühlkörper zu legen. Auch damit lassen sich die angesprochenen Probleme nicht zufriedenstellend lösen.

Der Erfindung liegt davon ausgehend die Aufgabe zugrunde, ein Stromrichtermodul der eingangs genannten Art zu schaffen, bei dem die während des Betriebs auftretenden Wärmespannungen nicht zu einem Defekt des Moduls führen können.

Diese Aufgabe wird bei einen Stromrichtermodul nach dem Oberbegriff des Anspruchs 1 durch dessen kennzeichnende Merkmale gelöst.

Die mit der Erfindung erzielbaren Vorteile liegen insbesondere darin, daß das Stromrichtermodul kostengünstig herstellbar ist und einen guten Wärmeübergang zum Kühlkörper gewährleistet. Durch die Beschichtung der Keramikplatte mit Kupferfolie auf der dem Gehäuseinneren abgewandten Seite werden durch "Bimetalleffekte" hervorgerufene Wärmeverspannungen vermieden. Ferner wird das spröde und bruchempfindliche Keramiksubstrat zusätzlich geschützt, d.h. bei Unebenheiten des Kühlkörpers und vorhandenen Staubkörnern auf den Montageflächen besteht keine Gefahr von Keramikbrüchen, und damit des Verlustes der Isolationsfähigkeit zwischen den internen elektrischen Verbindungen des Stromrichtermoduls und dem Kühlkörper.

Ein Ausführungsbeispiel der Erfindung ist nachfolgend anhand der Zeichnungen erläutert. Es zeigen:

Fig. 1 einen Schnitt durch die Breitseite eines Stromrichtermoduls,

Fig. 2 einen Schnitt durch die Schmalseite des Moduls.

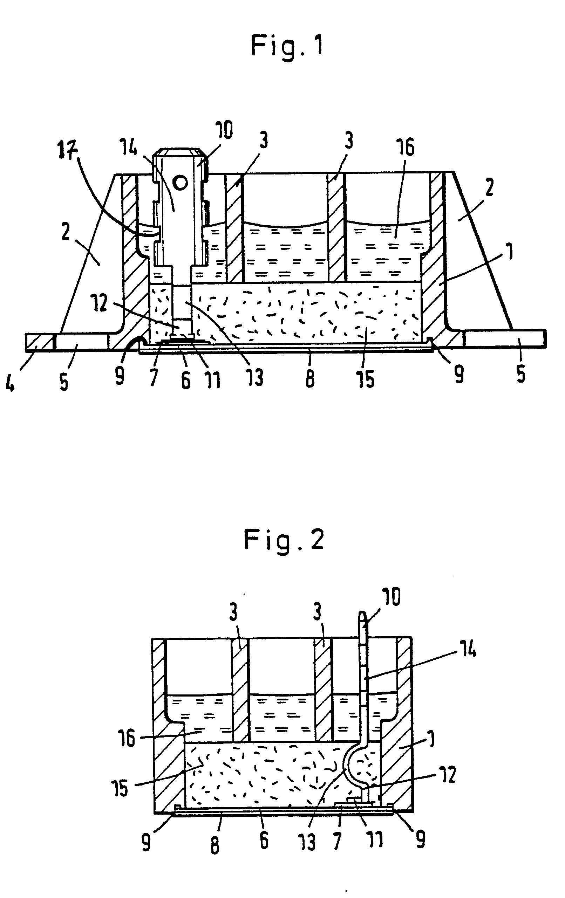

In Fig. 1 ist ein Schnitt durch die Breitseite des Stromrichtermoduls dargestellt. Das Modul besitzt einen oben und unten offenen Rahmen 1, der als Gehäusewandung dient. Der Rahmen 1 weist an seinen beiden Schmalseiten Versteifungskanten 2 auf. Zur Erhöhung der Stabilität besitzt der Rahmen 1 ferner mehrere parallel zur Breitseite bzw. Schmalseite verlaufende Rippen 3. Beim Stromrichtermodul des Ausführungsbeispiels verlaufen zwei Rippen 3 parallel zur Breitseite und zwei Rippen 3 parallel zur Schmalseite. Hierdurch ergeben sich neun rechteckförmige Zellen zur Aufnahme von externen Anschlußelementen für das Modul. Die Rippen 3 dienen gleichzeitig als Isolation und Kriechwegverlängerung zwischen den externen Anschlußelementen. Der Rahmen 1 weist an seinen beiden Schmalseiten in Höhe der Bodenfläche Befestigungslaschen 4 auf. Diese Befestigungslaschen 4 sind mit Bohrungen bzw.

U-förmigen Ausnehmungen 5 zur Montage des Stromrichtermoduls auf einem Kühlkörper versehen.

Das Gehäuse des Stromrichtermoduls wird zum einen durch den Rahmen 1, zum anderen durch eine in eine Vertiefung der Bodenfläche des offenen Rahmens 1 aufgesetzte Keramikplatte 6 gebildet. Die Keramikplatte 6 weist Metallisierungen 7 auf ihrer dem Gehäuseinneren zugewandten Fläche auf. Diese Metallisierungen 7 werden beispielsweise durch Kupferfolie realisiert, die gemäß dem aus dem "DE-A-30 36 128, Offenlegungstag 1.4.82" bekannten Verfahren direkt ohne Zwischenschicht auf die Keramik aufgebracht sind. Die Metallisierungen 7 dienen als Leiterbahnen und Kontaktflächen zum Auflöten von Anschlußelementen, Halbleiterbauelementen und internen Verbindungslaschen.

Zur mechanischen Stabilisierung der Keramikplatte 6 ist eine dicke Kupferfolie 8 ebenfalls gemäß dem Verfahren nach Patentanmeldung P 30 26 128.5 direkt auf die dem Gehäuseinneren abgewandten Seite der Keramikplatte 6 aufgebracht. Die Stärke der Kupferfolie 8 entspricht ungefähr der Stärke der Metallisierungen 7 (vorzugsweise ebenfalls Kupferfolien). Dadurch werden Verspannungen, die sich infolge der Herstellprozesse und der einseitigen Lötprozesse auf der dem Gehäuseinneren zugewandten Seite der Keramikplatte 6 ergeben, wirksam verhindert. Desweiteren ermöglicht die Kupferfolie 8 einen guten Wärmekontakt zu einem mit dem Modul verbundenen Kühlkörper. Auch ist die Gefahr von Keramikbrüchen infolge unebener und verschmutzter (Staubkörner) Kühlkörper wesentlich geringer.

Der Rahmen 1 und die Keramikplatte 6 werden miteinander verklebt. Zur genauen Fixierung der Platte 6 weist der Rahmen 1 die bereits erwähnte umlaufende Vertiefung in seiner Bodenfläche auf, deren Tiefe ungefähr der Dicke der Keramikplatte 6 entspricht. Eine in dieser Vertiefung des Rahmens 1 vorgesehene umlaufende Nut 9 dient dabei zur Aufnahme von austretendem Klebstoff. Der überschüssige Klebstoff wandert in die Nut 9 und quillt nicht über den Rand der Keramikplatte 6 auf die Kühlfläche. Eine mit herausquellendem Klebstoff verschmutzte Kühlfläche der Keramikplatte 6 müßte in nachteiliger Weise zusätzlich bearbeitet werden, um die Klebstoffreste zu entfernen. Anderenfalls wäre der Wärmeübergang zum Kühlkörper behindert.

Mit der Metallisierung 7 ist ein Flachstecker 10 als Anschlußelement für einen externen Steckkontakt verlötet. In den Figuren 1 und 2 ist nur ein Flachstecker dargestellt, das Modul des Ausführungsbeispieles kann jedoch insgesamt bis zu neun derartige Flachstecker aufweisen. Der Flachstecker 10 ist auf der Oberseite des Gehäuses frei zugänglich. Er besitzt ein verbreitertes Fußteil 11 zur mechanischen Stabilisierung der Lötstelle auf der Metallisierung 7. An das verbreiterte Fußteil 11 schließen sich eine Abwinkelung 12 und daran ein Dehnungsbogen 13 an. Die Ausführungsform der Abwinkelung 12 und des Dehnungsbogens 13 sind insbesondere aus der Fig. 2 ersichtlich. Der Dehnungsbogen 13 geht an seinem oberen Ende in den eigentlichen Steckanschluß 14 mit Einkerbungen 17 über. Der Dehnungsbogen 13 ist in seinem Querschnitt kleiner als die Querschnitte des oberen Steckanschlusses 14 und des unteren Fußteiles 11. Der Dehnungsbogen 13 vermeidet hohe zyklische Zugspannungen auf die Lötverbindung zwischen Fußteil 11 und Metallisierung 7 der Keramikplatte 6.

Das mit der Keramikplatte 6 verklebte und mit Halbleiterbauteilen und Flachsteckern bestückte Gehäuse wird in seinem unteren Teil mit einer weichen Vergußmasse (z.B. Silikonkautschuk) 15 zum Schutz der empfindlichen Aktivteile vergossen und zwar sollte der Dehnungsbogen 13 des Flachsteckers 10 voll mit Silikonkautschuk 15 vergossen sein. Das Verschließen des Gehäuses bis knapp über die Gehäusemitte erfolgt mit einer harten Vergußmasse 16 (z.B. Epoxidharz). Durch die harte Vergußmasse 16 werden insbesondere die Flachstecker 10 an ihren Einkerbungen 17 mechanisch stabilisiert.

In Fig. 2 ist ein Schnitt durch die Schmalseite des Stromrichtermoduls dargestellt. Es sind insbesondere der Rahmen 1 mit den Rippen 3 und der umlaufenden Nut 9 zur Klebstoffrestaufnahme ersichtlich. Die den Gehäuseboden bildende Keramikplatte 6 ist einerseits mit der Metallisierung 7, andererseits mit der Kupferfolie 8 beschichtet. Auf die Metallisierung 7 ist der Flachstecker 10 mit seinem Fußteil 11 verlötet. Das Fußteil 11 geht über die Abwinkelung in den Dehnungsbogen 13 über, an den sich der eigentliche Steckanschluß 14 anschließt. Ferner ist die im unteren Gehäuseteil eingegossene weiche Vergußmasse 15 sowie die im mittleren Gehäuseteil eingegossene harte Vergußmasse 16 dargestellt. Das obere Gehäuseteil bleibt zum externen Anschluß der Flachstecker frei von Vergußmassen.

## Patentansprüche

1. Stromrichtermodul mit einem oben und unten offenen Rahmen als Gehäusewandung und einer mit dem Rahmen verklebten Keramikplatte als Gehäuseboden, wobei die Keramikplatte auf ihrer dem Gehäuseinnerem zugewandten Seite Metallisierungen aufweist, die als Leiterbahnen zum Verlöten mit Halbleiterbauelementen, internen Verbindungslaschen und externen Anschlußelementen dienen, wobei die Anschlußelemente als auf der Oberseite des Gehäuses frei zugängliche und im Gehäuse mit einer Metallisierung verlötete Flachstecker ausgebildet sind, und wobei das Gehäuse mit einer Vergußmasse etwa zur Hälfte ausgegossen

ist, <u>dadurch gekennzeichnet</u>, daß die Keramikplatte (6) auf ihrer dem Gehäuseinneren abgewandten Seite mit einer direkt mit der Keramikplatte (6) verbundenen Kupferfolie (8) versehen ist, wobei die Stärke der Kupferfolie (8) ungefähr gleich ist der Stärke der vorzugsweise ebenfalls nach einem direct-bonding-Verfahren aufgebrachten Metallisierungen (7) und daß die Flachstecker (10) einen Dehnungsbogen (13) zwischen einem verbreiterten, anlötbaren Fußteil (11) und dem eigentlichen Steckanschluß (14) aufweisen, wobei der Querschnitt des Dehnungsbogens (13) kleiner ist als der Querschnitt des übrigen Flachsteckers (10).

2. Stromrichtermodul nach Anspruch 1, dadurch gekennzeichnet, daß der Rahmen (1) an seiner zum Verkleben mit der Keramikplatte (6) vorgesehenen unteren Vertiefung eine umlaufende Nut (9) aufweist.

**Claims**

1. Static converter module having as a housing wall a frame which is open at the top and at the bottom and as a housing bottom a ceramic plate which is bonded to the frame, in which arrangement the ceramic plate has, on its side facing the inside of the housing, metal coatings which are used as conductor tracks for soldering to semiconductor components, internal connecting lugs and external connecting elements, the connecting elements being constructed as flat plugs which are freely accessible at the top of the housing and which are soldered to a metal coating in the housing, and the housing being approximately half filled with a casting compound, characterized in that the ceramic plate (6) is provided on its side facing away from the inside of the housing with a copper foil (8) which is connected directly to the ceramic plate (6), the thickness of the copper foil (8) being approximately equal to the thickness of the metal coatings (7), which are preferably also applied in accordance with a direct-bonding method, and that the flat plugs (10) are provided with an expansion loop (13) between a widened foot part (11), which can be soldered on, and the actual plug connection (14), the cross-section of the expansion loop (13) being smaller that the cross-section of the remaining flat plug (10).

2. Static converter module according to Claim 1, characterized in that the frame (1) has at its lower recess, provided for bonding to the ceramic plate (6), a peripheral groove (9).

**Revendications**

1. Module convertisseur statique de courant comprenant un cadre ouvert en haut et en bas en tant que paroi du boîtier et une plaque de céramique collée sur le cadre en tant que fond du boîtier, la plaque de céramique étant munie, sur sa face tournée du côté de l'intérieur du boîtier, de dépôts de métal qui servent de connexions pour le brasage avec des composant à semiconducteurs, des barrettes de connexion internes et des éléments de raccordement externes, les éléments de raccordement étant réalisés sous la forme de fiches plates librement accessibles sur la face supérieure du boîtier et brasées dans le boîtier à un dépôt de métal et le boîtier étant à peu près à moitié rempli d'une masse de scellement, caractérisé par le fait que la plaque de de céramique (6), sur sa face tournée du côté opposé à l'intérieur du boîtier, est revêtue d'une feuille de cuivre (8) directement raccordée à la plaque de céramique (6), l'épaisseur de la feuille de cuivre (8) étant à peu près égale à l'épaisseur des dépôts de métal (7) appliqués de préférence par un procédé de bonding direct et que les fiches plates (10) comportent un arc de dilatation (13) situé entre un pied (11) élargi et brasable et la prise de courant embrochable proprement dite (14), la section transversale de l'arc de dilatation (13) étant plus petite que la section transversale du reste de la fiche plate (10).

2. Module convertisseur selon la revendication 1, caractérisé par le fait que le cadre (1) comporte une rainure périphérique (9) au niveau de son creux inférieur prévu pour le collage à la plaque de céramique (6).

## Fig. 1

## Fig. 2